# EUROPÄISCHE PATENTANMELDUNG

(11) **EP 3 209 099 A1**
(43) Veröffentlichungstag der Anmeldung: **23.08.2017**
(21) Anmeldenummer: 17157338.9
(22) Anmeldetag: 22.02.2017
(51) Int. Cl.: H05K 3/02, H01L 25/13, F21S 4/24, H05K 3/00

(54) **HERSTELLUNGSVERFAHREN FÜR EINE LEUCHTENKOMPONENTE UND MIT DEM VERFAHREN HERGESTELLTE LEUCHTENKOMPONENTE**

(30) Priorität: 22.02.2016 DE 102016103047
(71) Anmelder: ITZ Innovations- und Technologiezentrum GmbH, 59759 Arnsberg (DE)
(72) Erfinder: MARQUAS, Karsten, 59757 Arnsberg (DE); DREES, Frank, 58840 Plettenberg (DE)
(74) Vertreter: Lippert Stachow Patentanwälte Rechtsanwälte

(57) **Zusammenfassung**

Die Erfindung betrifft ein Verfahren zur Herstellung einer Leuchtenkomponente ausgebildet zur Aufnahme einer einen Lichtstrom ausstrahlenden LED 10. Die LED 10 ist auf einem flächigen, teilweise leitfähigen Leiterelement angeordnet.

Um die Durchlaufzeiten der Herstellung einer Leuchtenkomponente zur reduzieren wird erfindungsgemäß ein Herstellungsverfahren vorgeschlagen, welches die Verfahrensschritte aufweist : Anordnen und Vorfixieren eines Leiterstreifens 2 in einer Sollposition in einem Spritzgusswerkzeug, Hinterspritzen des Leiterstreifens mit Kunststoff zur Erzeugung der mit dem Leiterstreifen verbundenen Leuchtenkomponente, Laserschneiden einer benötigten Leitungsgeometrie in den Leiterstreifen 2 zum Erstellen eines strukturierten Leiterstreifens 2 sowie Aufbringen von elektrischen und/oder elektronischen Komponenten auf dem strukturierten Leiterstreifen.

## Beschreibung

Die Erfindung betrifft ein Verfahren zur Herstellung einer Leuchtenkomponente ausgebildet zur Verbindung mit einem Bauträger und zur Aufnahme eines einen Lichtstrom ausstrahlenden und LEDs umfassenden Leuchtmittels, wobei die LEDs auf einem flächigen, zumindest teilweise leitfähigen Leiterelement zur Verwirklichung einer definierten Sehaufgabe angeordnet sind.

### Stand der Technik

Dabei stellt die LED das Licht emittierende HalbleiterBauelement dar, welches üblicherweise auf einer Leiterplatte angeordnet ist, die als PCB (Printed Circuit Board) bezeichnet wird. Das PCB und die darauf angeordneten LEDs mit weiteren elektronischen Komponenten, wie z. B. Betriebsgeräten, Treibern oder dergleichen werden auch als "LED-Modul" bekannter Bauart bezeichnet.

Das Leiterelement ist ein auf Länge und Breite vorgefertigtes und flächiges Bauteil, vorzugsweise ausgebildet als ein Kupferblechstreifen oder ein kupferbeschichteter Aluminiumstreifen, der meistens eine größere Länge als Breite aufweist. Praktisch sind hier beliebige Abmessungen realisierbar, welche von dem jeweiligen Anwendungsfall abhängen. Das Leiterelement ist ferner flächig, weist also eine im Verhältnis zur Länge und Breite deutlich geringere Dicke auf. Die durch ein Leiterelement aufgespannte Ebene wird im Sinne dieser Erfindung als Hauptebene bezeichnet.

### Nachteile am Stand der Technik

Hintergrund ist die derzeitige Fertigung von LED Modulen, welche grundsätzlich ein Trägerelement umfassen, auf welchem eine Leiterbahnen angeordnet wird und häufig einfach als "PCB" (Printed Circuit Board) bezeichnet werden. Das derzeitige Herstellungsverfahren dieser PCBs und damit auch der LED-Module erfordert somit zahlreiche kostenintensive Prozessschritte, bei denen umweltkritische Chemikalien verwendet werden, z.B. für das Ätzen, Galvanisieren und Reinigen. Zunächst ist die Fertigung eines PCB an sich relativ kompliziert und deshalb aufwendig. Sodann muss dieses PCB gelagert und bestückt werden mit LEDs und sonstigen Anschlusselementen. Schließlich muss das PCB händisch oder auch maschinell auf dem Kunststoffträger durch Kleben, Schrauben oder mit Clips befestigt werden. Die einzelnen Schritte und der damit zwangsweise verbundene diskontinuierliche Produktionsprozess verhindern eine Einbindung in die kontinuierliche, durchlaufende Produktion.

### Technisches Problem (Aufgabe)

Ausgehend von diesem Stand der Technik und der damit verbundenen Nachteile liegt der Erfindung die Aufgabe zugrunde, diese Nachteile zumindest teilweise zu vermeiden und insbesondere ein Fertigungsverfahren vorzusehen, welches die Durchlaufzeiten der Produktion von Leuchten und damit die damit verbundenen Kosten reduziert.

### Erfindung

Erfindungsgemäß wird diese Aufgabe bereits durch ein Herstellungsverfahren gelöst, welches die Verfahrensschritte umfasst: Anordnen und Vorfixieren eines Leiterstreifens in einer Sollposition in einem Spritzgusswerkzeug; Hinterspritzen des Leiterstreifens mit Kunststoff zur Erzeugung eines mit dem Leiterstreifen verbundenen Leuchtenbauteils; Laserschneiden einer benötigten Leitungsgeometrie in den Leiterstreifen zur Erstellung eines strukturierten Leiterstreifens und Aufbringen von elektrischen und/oder elektronischen Komponenten auf den strukturierten Leiterstreifen. Der besondere Vorteil dieses Fertigungsverfahrens liegt darin, dass dieses hauptsächlich physikalisch abläuft und somit im Gegensatz zum Stand der Technik keine umweltkritischen Chemikalien erforderlich sind.

Vorzugsweise weist der Leiterstreifen eine Materialstärke bzw. ein Nennmaß zwischen 18 bis 400 Mikrometern (µm) auf, vorzugsweise 70 Mikrometer. Die durch den Leiterstreifen bzw. das Leiterelement aufgespannte Ebene wird im Sinne dieser Erfindung als Hauptebene bezeichnet.

Als Leuchtenkomponente im Sinne der Erfindung ist jedes Bauteil zu verstehen, welches einen Kunststoffträger und einen darauf angeordneten Leiterstreifen umfasst. Dieses kann also ein in ein Leuchtengehäuse zu verbauendes, lichterzeugendes Bauteil sein, wie z.B. ein neuartig aufgebautes LED-Modul, welches dann ohne PCB ausgebildet ist, oder auch ein Leuchtengehäuse selbst sein, in dem dann mindestens ein Leiterstreifen integriert ist.

Das erfindungsgemäße Verfahren bietet in seiner grundsätzlichen und allgemeinsten Ausgestaltung bereits zahlreiche Vorteile. Zum einen kann der Laser sehr filigrane Strukturen mit 1/10 Millimeters erzeugen, was der zunehmenden Verwendung von kleineren LEDs entgegenkommt, und gegenüber dem Stanzen mit typischen Spaltmaßen von 0,8 bis 1,2 eine erhebliche Verbesserung von mindestens 63 Prozent darstellt. Im Gegensatz zu bisherigen Produktionsverfahren, in denen Thermoplaste eingesetzt werden, können bei dem erfindungsgemäßen Herstellungsverfahren Duroplaste eingesetzt werden, die aufgrund ihrer Trifunktionalität und engmaschigen Aufbaus ein besseres Brandverhalten, geringeren thermischen Ausdehnungskoeffizienten sowie bessere Wärmeleitwerte gegenüber Thermoplasten bei vergleichsweise geringeren Kosten aufweisen. Die Fertigung kann somit erstmalig in einem integrierten Spritzguss-Produktionsprozess unter Einbindung von Leiterbahnen und Anschlusselementen erfolgen, was die Durchlaufzeiten der Produktion gegenüber bekannten Verfahren erheblich reduziert.

Bei einer bevorzugten Weiterentwicklung werden Kontakte, insbesondere umfassend Kontaktstifte, Stifte usw. entweder im Hauptspritzgussprozess eingespritzt oder es werden Öffnungen für deren Aufnahme vorgesehen, in welche die Kontaktstifte eingeschossen werden, also nachträglich in diese Öffnungen eingepresst werden..

Diese Kontaktstifte ragen insbesondere quer zur Hauptebene und sind mit ihren oberseitigen Stirnenden in Befestigungsöffnungen des Leiterelements eingesetzt und dort verlötet. Diese Kontaktstifte können entweder in den Hauptspritzgussprozess integriert sein oder in das noch zähflüssige Kunststoffmaterial eingeschossen werden.

Bevorzugt läuft das Herstellungsverfahren voll- oder semiautomatisch in einer Produktionsanlage ab, insbesondere durch Einbindung von Robotern. Diese automatische Fertigung kann entweder in einzelnen Fertigungszellen nach dem Rotationsprinzip oder in einer Fertigungslinie erfolgen.

Durch die Wahl geeigneter Prozessparameter des Laserabtragprozesses, also insbesondere Veränderung der Leistung und/oder Fokussierung wird gewährleistet, dass lediglich das Leitungselement an den gewünschten Stellen abgetragen wird, nicht aber der darunter liegende Kunststoff- bzw. Kunststoffträger, also Einstellen der Stromstärke und/oder des Fokus und/oder der Vorschubgeschwindigkeit des Lasers sowie beliebige Kombinationen dieser Prozessparameter.

Wichtig ist, dass beim Spritzgießen des Kunststoffträgers kein Kunststoff auf die zu bestückende Vorderseite des Leiterelements gelangt, diese also frei von Kunststoff bleibt. Dieses wird vorzugsweise dadurch erzielt, indem man elastische Kunststoffeinsätzen als Gegenlager in das Werkzeug einbringt.

Bevorzugt durchtrennt der Laser den Kunststoffträger beim Laserabtragprozess nicht, so dass der Kunststoffträger also ein einstückiges bleibt und nicht in zwei Hälften getrennt wird.

Bei einer bevorzugten Weiterentwicklung kann der Laser mit einer Leistung betrieben werden, welche auch den Basis- oder Trägerwerkstoff durchtrennt bzw. abträgt. Dabei kann in oder an dem Kunststoffträger ein Blockierelement vorgesehen sein, welches also das Durchdringen des Laserstrahls durch den Kunststoff unterhalb des Blockierelements unterbindet, also auch bei einer höheren Leistung, bei welchem der Laserstrahl schneller das Leiterelement mit der Struktur versieht, aber bei welcher dieser ohne dieses Blockierelement den darunter liegenden Kunststoff durchtrennen würde. Dieses Blockierelement ist vorzugsweise als Blockierschicht, insbesondere Blockierplatte ausgebildet, die also geometrisch an das Leitungselement angepasst ist aber nicht muss. Vorzugsweise weist die Blockierplatte etwa die Abmessung des Leiterelements auf, ist aber mindestens so groß, dass diese in der Sollposition unterhalb der Abtragstelle angeordnet ist, an welcher der Laser beim Laserschneiden das Material des Leitungselements abträgt oder durchtrennt. Dieses Blockierelement ist vorzugsweise ausgebildet als Blockierplatte kann auf der Rückseite des Kunststoffträgers angeordnet sein, so dass der Kunststoffträger also sandwichartig zwischen Leiterelement und Blockierplatte eingefasst ist. Bevorzugt besteht das Blockierelement im Wesentlichen aus Metall und/oder Keramik. Das Blockierelement kann auch in den Kunststoff eingelassen oder eingespritzt bzw. umspritzt sein, z.B. aus einem laserabsorbierenden Kunststoff oder im 2K-Verfahren gespritzt sein.

Besonders niedrige Zykluszeiten und insofern eine besonders schnelle Produktion lassen sich realisieren, wenn in dem unter dem Leiterelement liegenden Kunststoff beim Spritzgießen Freibereiche korrespondierend zu den strukturierten Ausnehmungen des Leiterelements vorgesehen sind. Durch diese Ausbildung kann der Laser beim Laserschneiden im Prinzip beliebig hohe Leistung verwenden, womit insofern dann auch sehr schnelle Produktionsprozesse mit Zykluszeiten von 1 Minute pro Bauteil realisierbar sind.

Eine besonders gute Verbindung des Kunststoffträgers mit dem Leiterelement kann erzielt werden durch mindestens eine Durchtrittsöffnung umfassen, durch welche der Kunststoff beim Hinterspritzen hindurchtritt. Vorzugsweise sind mehrere Öffnungen in regelmäßigen und unregelmäßigen Abständen vorgesehen, durch welche der Kunststoff beim Spritzgießen durchtritt. Eine noch bessere Verdingung wird erzielt, wenn der Kunststoff die Leiterplatte auf der Vorderseite formschlüssig umgreift. Diese so gebildeten Kunststoffbrücken bzw. Vorsprünge bleiben beim Lasern der Struktur erhalten und verbinden somit die entstehenden Leiterelemente dauerhaft mit dem Kunststoffträger.

Das Leiterelement kann zudem eine oder mehrere Öffnungen umfassen, die als Aufnahme-, Stromzuführungs-, oder Verdrehschutzöffnungen dienen und verschiedene Geometrien aufweisen können, vorzugsweise aber rund oder eckig sind und in regelmäßigen oder unregelmäßigen Abständen zueinander in dem Leiterelement ausgebildet sind. Diese Öffnungen können zudem als Positionierhilfen zur Ausrichtung des Leiterelements in der Sollposition im Werkzeug dienen.

Die Positionierung des Leiterelements im Werkzeug erfolgt durch Stifte, welche in die Positionieröffnungen in dem Leiterelement eingreifen und mit denen dieses somit in der Sollposition in dem Werkzeug positioniert ist. Sodann schließt das Werkzeug und hinter- bzw. umspritzt den Leiterstreifen mit Kunststoff. Das Ergebnis ist ein mit Kunststoff hinterspritzter und einteilig verbundener Leiterstreifen oder ein Leuchtenbauteil bzw. eine Lichtkomponente mit integriertem Leiterstreifen.

Um eine uneingeschränkte Bewegung von Bestückungsautomaten (Dispensern) zu ermöglichen und die Durchlaufzeiten insofern weiter zu reduzieren, können in dem Leiterstreifen Vertiefungen zur Aufnahme von und zur Verbindung mit anderen elektrischen Komponenten ausgebildet sein. Diese Vertiefungen können z.B. als Senken ausgebildet sein, z. B. zur Aufnahme von Kontaktstiften. Diese Senken sind vorzugsweise so weit von der Hauptebene nach unten versetzt, dass das oberseitige Stirnende eines Kontaktstifts zwar ausreichend zu Verlöten ist, durch die Ebene der Senke aber nicht aber über die Hauptebene des Leiterstreifens herausragt, der Lotminiskus bzw. das Lötauge also vollständig in der Senke aufgenommen wird. Diese Vertiefungen können z.B. durch Stanzen oder Prägen des Leitungselements hergestellt werden.

Mehrere bevorzugte Ausführungsbeispiele des erfindungsgemäßen Verfahrens und damit hergestellter Leuchtenkomponenten sind in den Zeichnungen beispielhaft und nicht beschränkend dargestellt und werden im Folgenden näher beschrieben. In der Figurenbeschreibung wird

Richtungsterminologie wie etwa "oben", "unten", "vorne", "hinten", "vorderes", "hinteres", usw. in Bezug auf die Orientierung der beschriebenen Figur(en) verwendet. Da Komponenten von Ausführungsformen in einer Anzahl verschiedener Orientierung positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Die folgende ausführliche Beschreibung ist nicht im einschränkenden Sinne aufzufassen. Im Rahmen dieser Beschreibung werden die Begriffe "verbunden", "angeschlossen" sowie "integriert" verwendet zum Beschreiben sowohl einer direkten als auch einer indirekten Verbindung, eines direkten oder indirekten Anschlusses sowie einer direkten oder indirekten Integration.

In den Figuren werden identische oder ähnliche Elemente mit identischem Bezugszeichen versehen, soweit dieses zweckmäßig ist. Sofern mehrere identische Bauteile vorgesehen sind, sind diese regelmäßig nur mit einem Bezugszeichen bezeichnet. Die Darstellungen in den Figuren sind im Wesentlichen maßstäblich, jedoch können zur Veranschaulichung von Details bestimmte Bereiche für den Fachmann erkennbar größer dargestellt sein. Darüber hinaus können die Zeichnungen plakativ vereinfacht sein und enthalten nicht jedes bei der praktischen Ausführung gegebenenfalls vorhandene Detail.

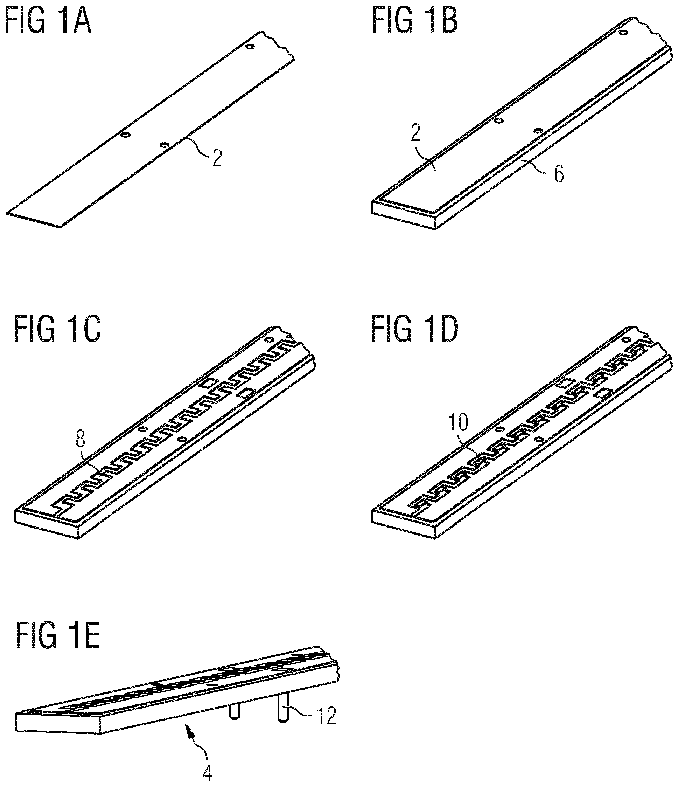

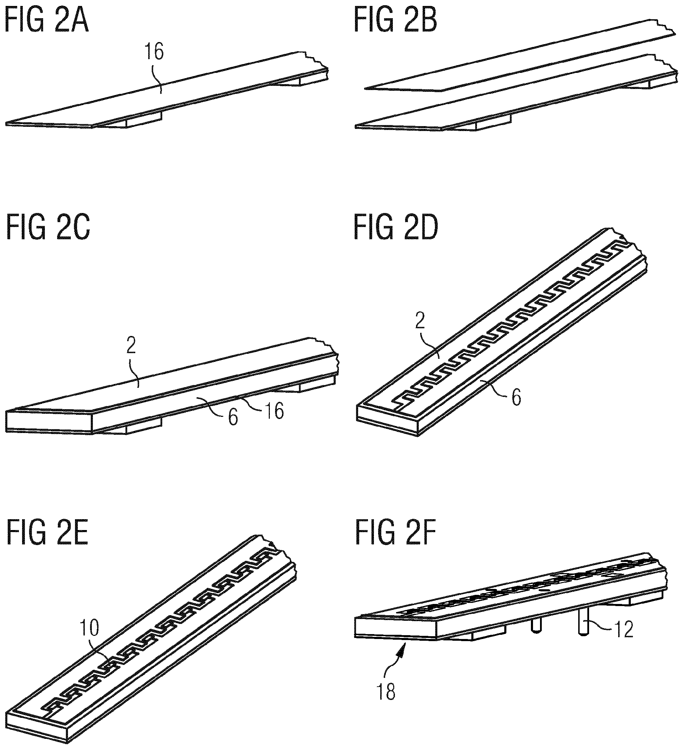

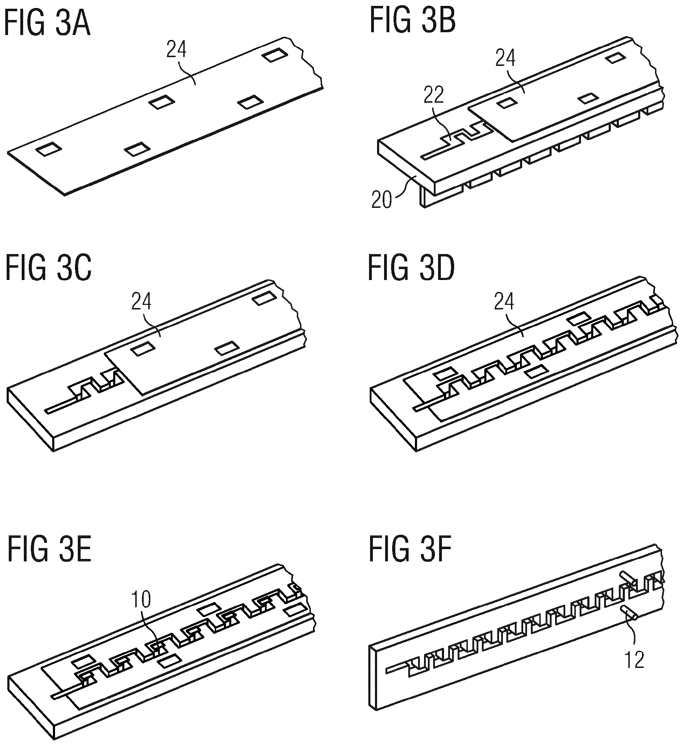

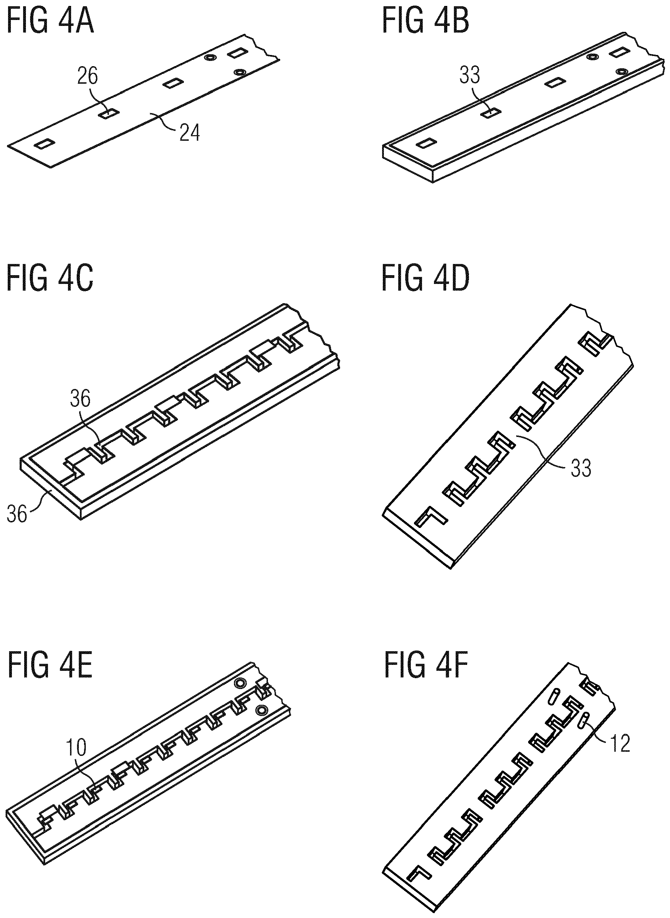

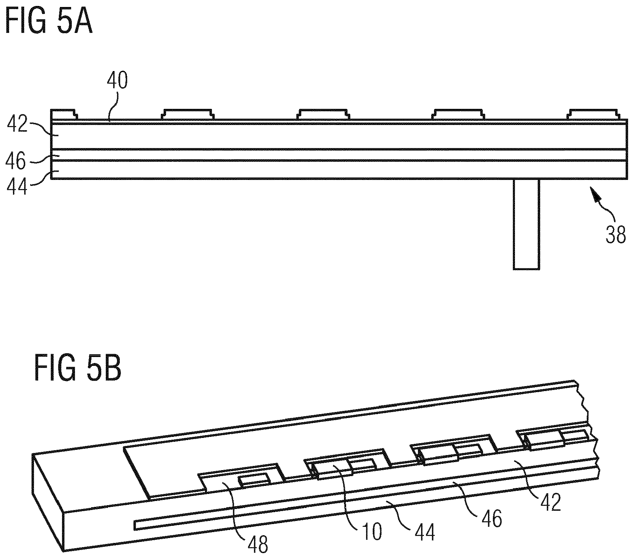

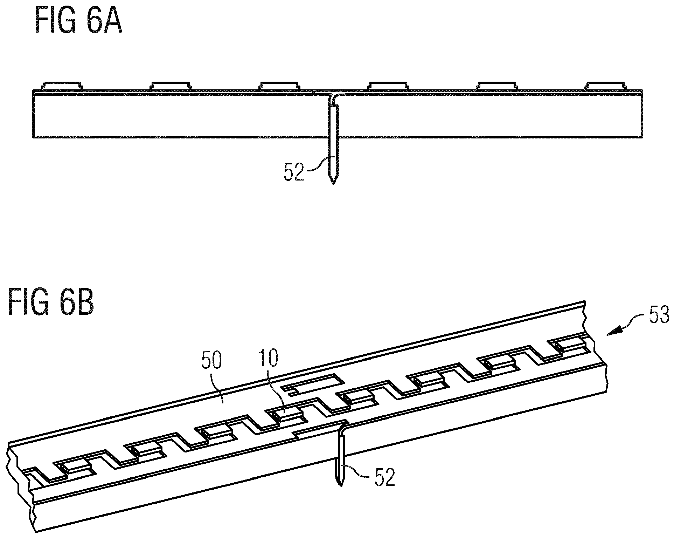

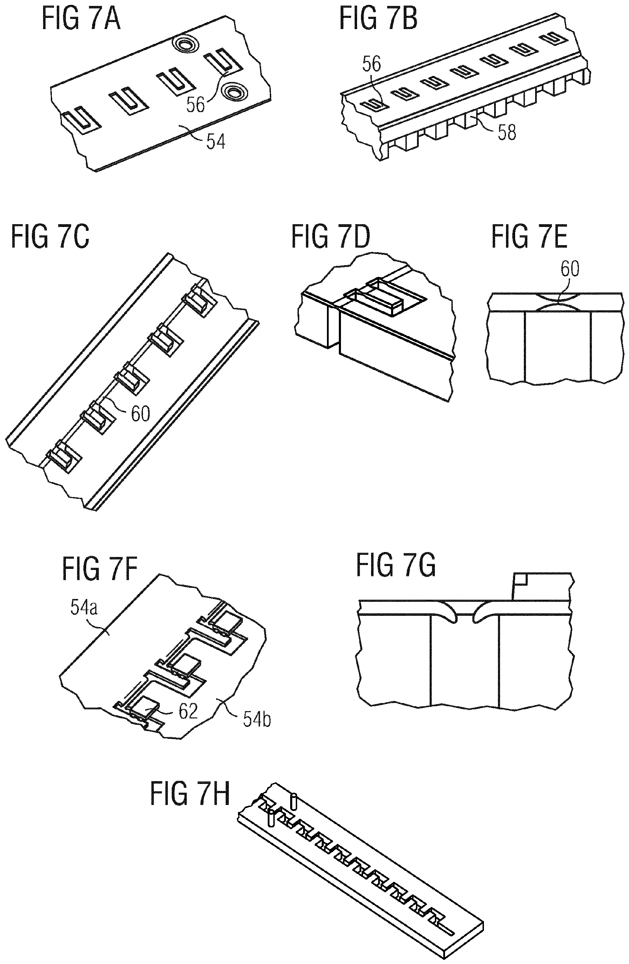

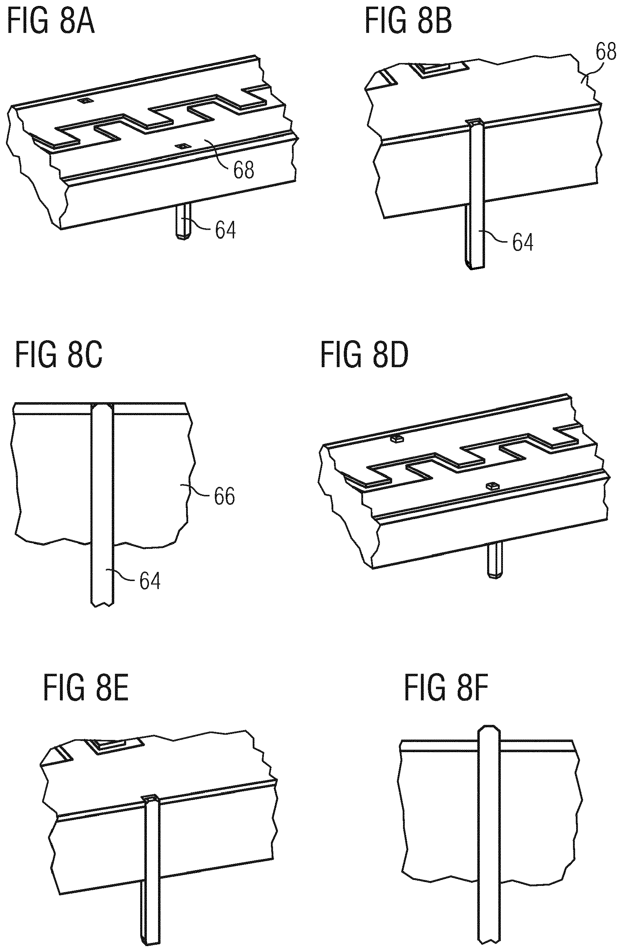

Alle Darstellungen bzw. Figuren stellen den Verfahrensablauf abstrahiert ohne die Werkzeuge dar, also ohne das Spritzgusswerkzeug und ohne den Laserroboter, verdeutlichen also den Status des Produktes, also der Leuchte nach jedem Verfahrensschritt.
Verfahrensablauf gemäß Figurenfolge 1:
   Der angelieferte längliche Leiterstreifen 2 wird zunächst gemäß Figur 1A in ein Spritzgusswerkzeug eingesetzt und in diesem in einer Sollposition fixiert gehalten.
   Sodann wird der Leiterstreifen 2 in dem Werkzeug in einer Sollposition positioniert gehalten, das Werkzeug schließt und hinter- bzw. umspritzt den Leiterstreifen 2 mit Kunststoff zur Bildung der als LED-Modul ausgebildeten 4 Leuchtenkomponente umfassend den mit dem Leiterstreifen 2 verbundenen Kunststoffträger 6. Das Endprodukt dieses Verfahrensschritts ist in Figur 1B darstellt.
   Nunmehr wird im Laserschnitt die benötigte und durchgehende oder diskontinuierliche Leitungsgeometrie 8 in den Leiterstreifen geschnitten, also das Material des Leiterstreifens abschnittsweise abgetragen, z.B. entlang einer sich längserstreckenden, zackenförmigen Strecke abgetragen, Figur 1C.
   Sodann werden die elektrischen Komponenten, also LEDs 10, Steckverbinder, Kontaktstifte und weitere elektronische Elemente auf die Oberseite des Leiterstreifens 2 aufgebracht, Figur 1D.
   Kontaktstifte 12 können in den Produktionsprozess integriert werden. Diese Kontaktstifte 12 ragen quer zur Hauptebene und sind mit ihren oberseitigen Stirnenden in Befestigungsöffnungen des Leiterstreifens 2 eingesetzt und dort verlötet. Diese Kontaktstifte 12, 14 können entweder in den Hauptspritzgussprozess integriert sein oder in das noch Kunststoffmaterial eingeschossen werden, Figur 1E.
Verfahrensablauf gemäß Figurenfolge 2:
   Bei dem Verfahrensablauf gemäß Figur 2 mit den Einzelfiguren 2A - 2F ist zusätzlich unter dem Kunststoffträger 6 ein als Blockierungselement fungierender Blockierstreifen 16 vorgesehen. Bei der Fertigung wird dieser größenmäßig an den Leiterstreifen angepasste Blockierstreifen 16 mit dem Leiterstreifen 2 in das Werkzeug eingesetzt und der Kunststoffträger 6 zwischen Leiterstreifen 2 und Blockierstreifen 16 gespritzt, so dass nach dem Spritzgießen der Blockierungsstreifen 16 beabstandet von dem Leiterstreifen 2 durch den Kunststoff 6, aber einteilig mit diesem verbunden ist. Dieses Blockierstreifen 16 dient dazu, einen Durchtritt des Lasers durch den Kunststoffträger 6 beim Laserschneiden des Leiterstreifens 2 zur Fertigung des LED-Moduls 18 zu unterbinden.
Verfahrensablauf gemäß Figurenfolge 3:
   Bei dem Verfahrensablauf in der Figurenfolge 3 umfassend Figuren 3A - 3F wird der Kunststoffträger 20 im ZweiKomponenten-Spritzgussverfahren hergestellt und umfasst in der Mitte einen Kern 22, welcher der später durch den Laser erzeugten Ausnehmung auf dem Leiterstreifen entspricht bzw. mit dieser korrespondiert. Dieser Kern 22 besteht aus einem Kunststoff, den der Laser beim Laserschneiden schneller entfernen kann als den umgebenden Kunststoffträger 20. Somit wird beim Laserschneiden eine durchgängige Öffnung in dem Kunststoffträger 20 unterhalb des Leiterstreifens 2 ausgebildet ist, wobei der Kunststoffträger 20 aber weiterhin einstückig ist, weil sich der Kern 22 bzw. die so erzeugte mittige Ausnehmung im Kunststoffträger 20 sich nicht bis zu dessen Stirnende erstreckt bzw. Verbindungsstege zwischen den beiden Seiten des Kunststoffträgers bestehen bleiben.
Verfahrensablauf gemäß Figurenfolge 4:
   Bei dem Verfahrensablauf gemäß Figur 4 umfassend die Einzeldarstellungen 4A - 4G sind in dem Leiterstreifen 24 in regelmäßigen Abständen und kollinear zu einer Seite von der Mittellinie des Leiterstreifens 24 versetzt angeordnete Durchtrittsöffnungen 26 vorgesehen.
   Durch diese Durchtrittsöffnungen 26 tritt beim Spritzgießen der Kunststoff bis in dieHauptebene des Leiterstreifens 24 und bildet insofern Anbindungsstege 33. Beim Laserschneiden können diese Anbindungsstege eine Verbindung zwischen den durch die Leitungsgeometrie gebildeten beiden Abschnitte des Kunststoffträgers 36 bilden, welche somit einem unbeabsichtigten Durchtrennen beim Laserschneiden entgegenwirken und das Arbeiten mit höherer Leistung erlauben. Alternativ kann der Laser die Leistung beim Erreichen der Anbindungsstege 33 zusätzlich reduzieren.
Bei dem Verfahrensablauf gemäß Figurenfolge 5 umfassend Einzelfiguren 5A und 5B zeigt Figur 5A einen vergrößerten Längsschnitt eines LED-Moduls 38. Dieses umfasst eine unterhalb des Leiterstreifens 40 zwischen einer oberen Kunststoffschicht 42 und einer unteren Kunststoffschicht 44 eingeschlossenen, streifenförmigen Metallkern 46, der gemäß der isometrischen Schnittdarstellung in Figur 5B innerhalb des Kunststoffträgers unterhalb des Leiterstreifens 40 zumindest im Bereich der Leitungsgeometrie eingeschlossen aufgenommen ist und als Blockierelement fungiert.
Bei dem Verfahrensablauf gemäß Figurenfolge 6 mit den Einzelfiguren 6A und 6B umfasst der Leiterstreifen 50 eine aus der Hauptebene quer nach unten ragende Kontaktspitze 52, die einstückig an dem Leiterstreifen 50 ausgebildet und nach unten gebogen ist, welche dann also beim Spritzgießen mit Kunststoff umspritzt wird und eine von zwei Kontaktspitzen zum Anschluss des so gebildeten LED-Moduls 53 bildet.
   Ein solcher Kontaktstift 52 kann somit einfach an jeder hier beschriebenen Ausführungsform vorgesehen sein, wobei diese entweder beim Laserschneiden ebenfalls ausgeschnitten oder ausgestanzt und dann umgebogen wird.
Der Verfahrensablauf gemäß Figurenfolge 7 mit den Einzeldarstellungen 7A bis 7H unterscheidet sich dadurch, dass in der Mitte des Leiterstreifens 54 in Längsrichtung kollinear und äquidistant zueinander beabstandete U-förmige Aussparungen 56 ausgestanzt sind, unterhalb denen ein korrespondierender Kern 58 angeordnet ist.
   Der Leiterstreifen 54 wird sodann mit Kunststoff um einen Kern 58 herum hinterspritzt und der Kern 58 sodann entfernt oder vom Laser ausgeschnitten, so dass die beiden Teile des Leiterstreifens 54 eine in Längsrichtung verlaufende Verbindungsbrücke 60 geringeren Querschnitts als die Nenndicke des Leiterstreifens besteht. Diese Verbindungsbrücke 60 wird sodann beim Laserschneiden durchtrennt, so dass der Leiterstreifen 54 in zwei vollständig getrennte Leiterstreifenteile 54a, 54b geteilt wird. Sodann werden LEDs 60 kollinear zueinander erstreckend zwischen den beiden Leiterstreifenteilen 54a, 54b aufgelötet.
Der Verfahrensablauf gemäß Figurenfolge 8 mit Einzelfiguren 8A bis 8C zeigt eine vergrößerte Darstellung einer möglichen Kontaktierungsart für einen Leitersteifen 68.

Bei der ersten Ausführungsform wird der Kontaktstift 64 quer erstreckend zu Hauptebene im Produktionsprozess in den Kunststoffträger 66 so eingelassen, dass dessen stirnseitiges Oberenden mit der Hauptebene des Leiterstreifen 68 abschließt.

Bei dem Verfahrensablauf und der Ausführungsform gemäß der Figurenfolge 9 mit den Einzelfiguren 9A - 9B ragt der Kontaktstift 64 mit dem Oberende über die Hauptebene des Leiterstreifens 68 hervor und wird sodann zusätzlich in einem weiteren Verfahrensschritt oberseitig mit dem Leiterstreifen 68 umfänglich verlötet. Die Kontaktstifte 64 sind also integral mit dem Leiterstreifen 68 ausgebildet und werden lediglich aus der durch den Leitersteifen 68 definierten Hauptebene heraus nach unten gebogen.

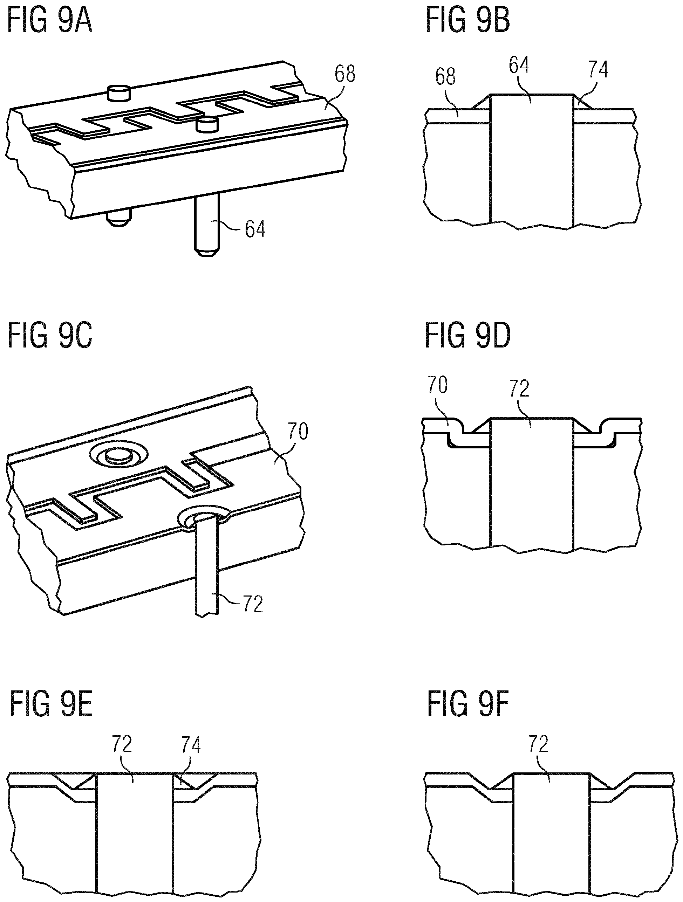

Diese auch gemäß über die Hauptebene des Leitersteifens 68 herausragenden Kontaktstifte 64 können aber den Arbeitsablauf von Bestückungsmaschine stören. Zur Vermeidung dieses Überstandes sind bei den Darstellungen gemäß Figuren 9C - 9F ringförmige tiefgezogene Bereiche mit jeweils einer zentralen Durchtrittsöffnung in dem Leiterstreifen 70 vorgesehen, in welche jeweils ein korrespondierend ausgebildeter Kontaktstift 72 stirnseitig einsetzbar ist. Die tiefgezogenen Bereiche sind dabei vorzugsweise soweit nach unten von der Hauptebene abgesenkt, dass die den Kontaktstift 72 vollständig umschließende Lötstelle 74 an dessen Stirnende vorgesehen werden kann, ohne dass der Kontaktstift 72 über die Hauptebene des Leiterstreifens 70 nach oben ragt. Die Kontaktstifte 72 können also nachträglich eingefügt werden, z.B. bei der Bestückung mit den LEDs. Somit steht beim Auftragen der Lotpaste (Rakelprozess) kein Kontaktstift über Hauptebene bzw. Oberfläche hervor. Mit dieser Ausgestaltung ist also eine besonders schnelle Bestückung zur weiteren Reduzierung der Durchlaufzeiten realisierbar.

Der Gegenstand der vorliegenden Erfindung ergibt sich nicht nur aus dem Gegenstand der einzelnen Patentansprüche, sondern aus der Kombination der einzelnen Patentansprüche untereinander. Alle in den Unterlagen - einschließlich der Zusammenfassung - offenbarten Angaben und Merkmale, insbesondere die in den Zeichnungen dargestellte räumliche Ausbildung werden als erfindungswesentlich beansprucht, soweit sie einzeln oder in Kombination gegenüber dem Stand der Technik neu sind.

### Bezugszeichenliste

- 2: Leiterstreifen
- 4: LED-Modul
- 6: Kunststoffträger
- 8: Leitungsgeometrie
- 10: LED
- 12: Kontaktstift
- 16: Blockierstreifen
- 18: Leuchtenkomponente
- 20: Kunststoffträger
- 22: Kern
- 24: Leiterstreifen
- 26: Durchtrittöffnung
- 33: Anbindungssteg
- 36: Kunststoffträger
- 38: LED-Modul
- 40: Leiterstreifen
- 42: obere Kunststoffschicht
- 44: untere Kunststoffschicht
- 46: Metallkern
- 48: Leitungsgeometrie
- 50: Leiterstreifen
- 52: Kontaktspitze
- 53: LED-Modul
- 54: Leiterstreifen
- 54a,b: Leiterstreifenteile
- 56: Auspaarung
- 58: Kern
- 60: Verbindungsbrücke
- 62: LED
- 64: Kontaktstift
- 66: Kunststoffträger
- 68: Leiterstreifen
- 70: Leiterstreifen
- 72: Kontaktstift
- 74: Lötstelle

## Patentansprüche

1. Verfahren zur Herstellung einer Leuchtenkomponente ausgebildet zur Verbindung mit einem Bauträger und zur Aufnahme eines einen Lichtstrom ausstrahlenden und LEDs (10; 62) umfassenden Leuchtmittels, wobei die LEDs (10; 62) auf einem flächigen, zumindest teilweise leitfähigen Leiterelement zur Verwirklichung einer definierten Sehaufgabe angeordnet sind, **GEKENNZEICHNET DURCH** die Verfahrensschritte Anordnen und Vorfixieren eines Leiterstreifens (2) in einer Sollposition in einem Spritzgusswerkzeug, Hinterspritzen des Leiterstreifens (2; 24; 40; 50; 54; 68; 70) mit Kunststoff zur Erzeugung der mit dem Leiterstreifen (2; 24; 40; 50; 54; 68; 70) verbundenen Leuchtenkomponente, Laserschneiden einer benötigten Leitungsgeometrie in den Leiterstreifen (2; 24; 40; 50; 54; 68; 70) zur Erstellung eines strukturierten Leiterstreifens (2; 24; 40; 50; 54; 68; 70) und Aufbringen von elektrischen und/oder elektronischen Komponenten auf den strukturierten Leiterstreifen (2; 24; 40; 50; 54; 68; 70).

2. Verfahren nach Anspruch 1, **DADURCH GEKENNZEICHNET, DASS** die Leistung des Lasers beim Laserschneiden der Leitungsgeometrie verändert wird.

3. Verfahren nach Anspruch 2, **DADURCH GEKENNZEICHNET, DASS** zur Änderung der Leistung die Stromstärke des Lasers verändert wird.

4. Verfahren nach Anspruch 3, **DADURCH GEKENNZEICHNET, DASS** zusätzlich der Fokus und/oder der Vorschub des Lasers verändert wird.

5. Verfahren nach einem der vorhergehenden Ansprüche, **DADURCH GEKENNZEICHNET, DASS** ein Blockierelement ausgebildet zur Blockierung der Laserstrahlen in den Kunststoffspritzgussprozess eingebunden wird.

6. Leuchtenkomponente hergestellt nach einem der vorgenannten Verfahrensansprüche mit einem Kunststoffträger (6; 20; 36) ausgebildet zum Tragen mindestens eines flächigen, zumindest teilweise leifähigen Trägerelement, an dem mindestens eine LED (10; 62) zur Erzeugung eines Lichtstroms befestigt ist, **DADURCH GEKENNZEICHNET, DASS** das Trägerelement als ein eine Hauptebene definierender Leiterstreifen (2; 24; 40; 50; 54; 68; 70) ausgebildet ist, der mit dem Kunststoffträger (6; 20; 36) hinterspritzt ist.

7. Leuchtenkomponente nach Anspruch 6, **DADURCH GEKENNZEICHNET, DASS** dieses ferner ein Blockierelement umfasst, welches zumindest unterhalb eines Bereichs angeordnet ist, in welchem beim Laserschneiden eine strukturierte Leitungsgeometrie in dem Leiterstreifen (2; 24; 40; 50; 54; 68; 70) ausgebildet ist.

8. Leuchtenkomponente nach einem der vorhergehenden Vorrichtungsansprüche, **DADURCH GEKENNZEICHNET, DASS** der Leiterstreifen (2; 24; 40; 50; 54; 68; 70) mindestens eine Durchtrittsöffnung (26) aufweist.

9. Leuchtenkomponente nach einem der vorhergehenden Vorrichtungsansprüche, **DADURCH GEKENNZEICHNET, DASS** der Leiterstreifen (2; 24; 40; 50; 54; 70) mindestens eine Vertiefung umfasst.

10. Leuchtenkomponente nach Anspruch 9, **DADURCH GEKENNZEICHNET, DASS** die Durchtrittsöffnung (26) in der Vertiefung angeordnet ist.

11. Leuchtenkomponente nach einem der vorhergehenden Vorrichtungsansprüche, **DADURCH GEKENNZEICHNET, DASS** der Leiterstreifen mindestens eine aus der Hauptebene ragende Kontaktspitze (52) aufweist.
